# EUROPÄISCHE PATENTSCHRIFT

(11) **EP 0 553 399 B1**
(45) Veröffentlichungstag und Bekanntmachung des Hinweises auf die Patenterteilung: **31.08.1994**
(21) Anmeldenummer: 92117071.8
(22) Anmeldetag: 06.10.1992
(51) Int. Cl.: H05K 9/00

(54) **Aufbausystem für Gehäuse der elektrischen Nachrichtentechnik**
Mounting system for cabinets of the electrical communication engineering.
Système de construction pour armoires de la technique électrique des communications.

(30) Priorität: 31.01.1992 DE 4203291
(43) Veröffentlichungstag der Anmeldung: 04.08.1993
(73) Patentinhaber: DETEWE - DEUTSCHE TELEPHONWERKE Aktiengesellschaft & Co., 10997 Berlin (DE)
(72) Erfinder: Brettschneider, Dieter, W-1000 Berlin 47 (DE); Klingbeil, Manfred, W-1000 Berlin 47 (DE); Krispin, Harro, W-1000 Berlin 27 (DE); Massmann, Manfred, W-1000 Berlin 45 (DE); Siebke, Uwe, W-1000 Berlin 12 (DE)

(56) Entgegenhaltungen:
- EP-A- 0 089 401
- FR-A- 2 651 386
- US-A- 4 679 867

## Beschreibung

Die Erfindung betrifft ein Aufbausystem für Gehäuse der elektrischen Nachrichtentechnik gemäß dem Oberbegriff des Anspruches 1.

FR-A-2651386 offenbart eine gegen elektromagnetische Störungen wirksame Schutzvorrichtung für Gestelle der Nachrichtentechnik.

In der elektrischen Nachrichtentechnik werden auf vermittlungstechnischer Seite die Anlage in aneinander gereihte Gestelle oder Gehäuse angeordnet. Aus wirtschaftlichen Gründen ist dabei eine raumsparende Aufbautechnik anzustreben, die zudem eine einfache Erweiterung gestattet.

Aufgabe der vorliegenden Erfindung war es, für digitale Netzknotenübertragungen ein Aufbausystem zu schaffen, das auf vorhandene andere Anlagensysteme abgestimmt ein einheitliches äußeres Erscheinungsbild bietet, obwohl diese Anlage für andere Frequenzbereiche funktional differenziert aufgebaut sind, sowie eine Schirmung gegen Störein- und Störabstrahlungen bis zu einer vorgegebenen maximalen Grenzfrequenz von typisch ein Gigahertz zu gewährleisten.

Diese Aufgabe ist durch die Erfindung gelöst, wie sie im Kennzeichnungsteil des ersten Anspruches dargelegt ist. Weitere vorteilhafte Maßnahmen sind Gegenstand der Unteransprüche.

Anhand einer aus sechs Figuren bestehenden Zeichnung wird die Erfindung nachfolgend näher erläutert. Darin zeigen die
- Fig. 1: einen Schrankrahmen, die
- Fig. 2: einen Baugruppenträger, die
- Fig. 3: die Frontsicht des geöffneten Baugruppenträgers nach Fig. 2, die
- Fig. 4: einen um 90° gedreht dargestellten Kabelverteiler, die
- Fig. 5: die Seitensicht des Kabelverteilers nach Fig. 4 und die
- Fig. 6: das Prinzip des Aufbausystems.

In allen Figuren tragen dieselben Ausformungen gleiche Bezugszeichen.

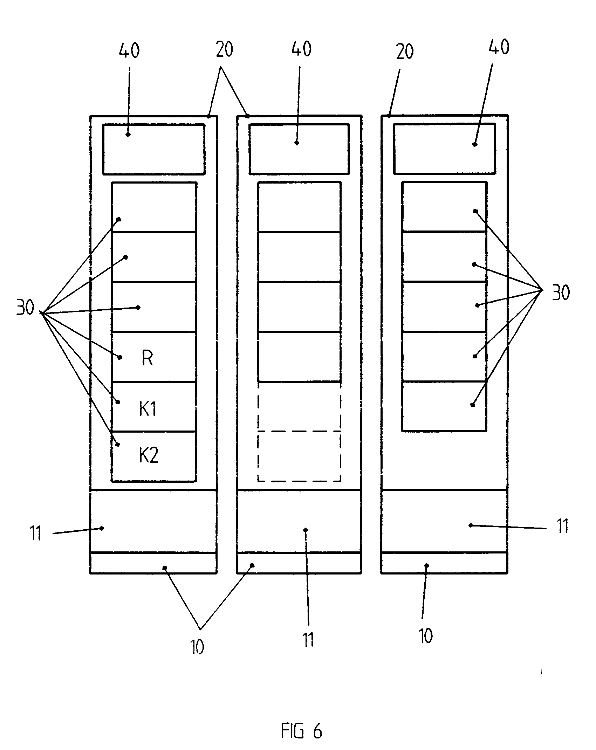

In der Fig. 6 ist das Bauprinzip der Gehäuse dargestellt. Jeweils auf einem Sockel 10 ist eine Stromversorgungseinheit 11 angeordnet. Auf dieser Stromversorgungseinheit 11 ist ein Schrankrahmen 20 befestigt. In einem Schrankrahmen 20 sind bis zu sechs Baugruppenträger 30 untergebracht und jeweils ein Kabelverteiler 40. Zweckmäßigerweise nehmen die beiden unteren Baugruppenträger 30 des ersten Gehäuses die Koppelfelder K1, K2 auf, über die der Rechner R der Anlage gesetzt ist. Der jeweils obere Platz ist den Kabelverteilern 40 reserviert. Die Gehäuse sind derart aufgestellt, daß das erste und das zweite Gehäuse sich rückseitig berühren. Die weiteren Gehäuse sind jeweils neben das erste und/oder zweite Gehäuse gestellt.

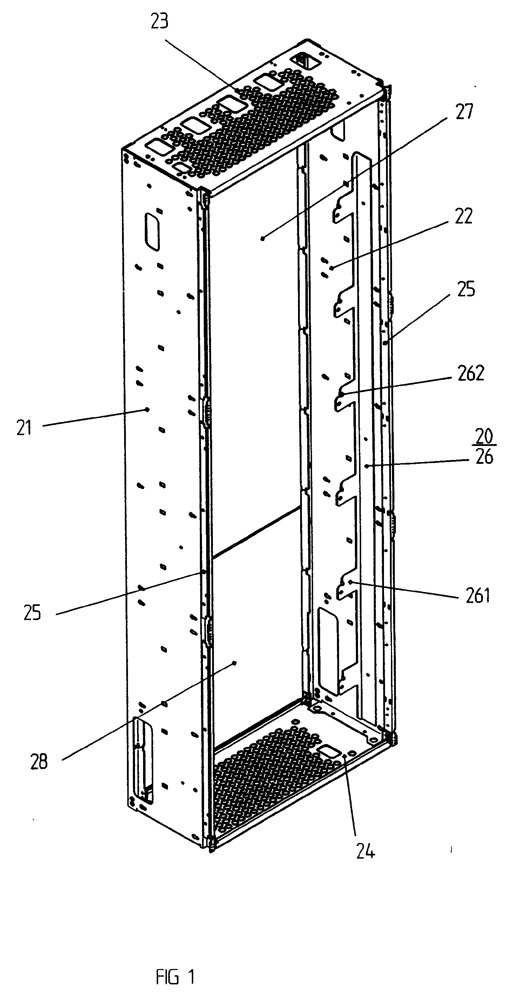

Der Schrankrahmen 20 (Fig. 1) wird aus zwei Profilseitenblechen 21, 22 sowie einem Abdeckblech 23 und einem Bodenblech 24 gebildet. Die Seitenbleche 21, 22 sind an ihrer vorderen Kante mit Leisten 25 versehen, die der Halterung von nicht gezeigten Türen dienen. Auf den Innenseiten der Seitenbleche 21, 22 sind in ihrer Ausführung unterschiedliche Profilleisten 26 zur Halterung der Baugruppenträger 30 stoffschlüssig durch Einpressen (Clinch-Technik) an verschiedenen Punkten befestigt. Dabei ist die in Figur 1 gezeigte rechtsseitige Profilleiste 26 mit größeren in den Innnenraum des Schrankrahmens 20 ragenden Befestigungslappen 261 versehen.

Die Rückseite des Schrankrahmens 20 wird durch Rückwände 27, 28 abgedeckt. Dabei entfällt im ersten und zweiten Gehäuse, die mit ihren Rückseiten aneinander stehen, jeweils die untere Rückwand 28, um so genügend Freiraum für die Koppelfeld-Verkabelung zu schaffen.

Die Seitenbleche 21, 22 des Schrankrahmens 20 weisen größere Öffnungen für die Kabeldurchführung zum Nebengehäuse und eine Vielzahl kleiner Lochungen zur Befestigung von Verkleidungsteilen auf. In dem Abdeckblech 23 und dem Bodenblech 24 sind größere Öffnungen zur Kabeldurchführung und eine Vielzahl kleinerer Lochungen zur Wärmeabfuhr vorhanden.

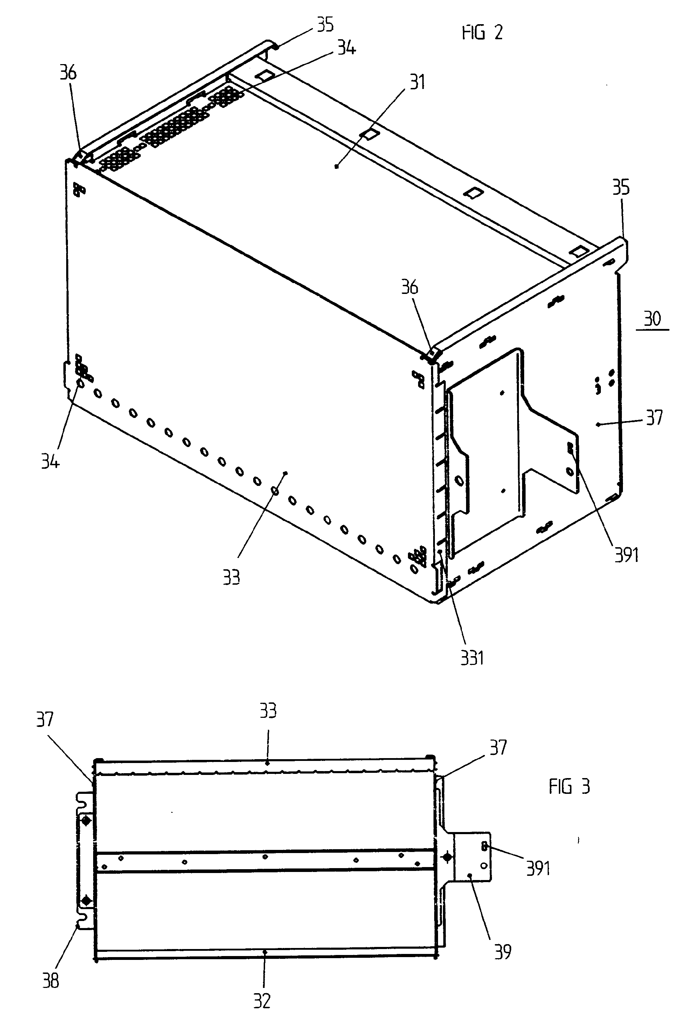

Die Baugruppenträger 30 (Fig. 2, 3) sind als geschirmte Gehäuse ausgeführt, ähnlich Faradayschen Käfigen. Dabei sind die obere Wand 31, die untere Wand 32 und die vordere Wand 33 in voller Breite und über die gesamte Tiefe mit Lüftungslöchern 34 zur Wärmeabfuhr versehen.

Die Seitenwände 37 sind an der oberen Wand 31 um 90° abgewinkelt. Diese Abwinkelungen dienen der Führung der vorderen Wand 33. Durch Abziehen der vorderen Wand 33 und Schwenken in eine waagerechte Lage kann diese über die obere Wand 31 geschoben werden, so daß der Innenraum des Baugruppenträgers 30 zugänglich ist. Die Abwinkelungen sind an der der Rückseite des Baugruppenträgers 30 zugewandten Seite als Anschlag 35 für die vordere Wand 33 gebogen. Die an der vorderen Wand 33 liegenden Enden der Abwinkelungen sind als Führung 36 schiefwinklig gestaltet. Die die Seitenwände 37 umgreifenden Falze 331 der vorderen Wand 33 sind eingeschnitten, so daß eine lösbare Verbindung durch Hafthaltung entsteht, die zudem eine wirksame elektrische Verbindung hinsichtlich der Abschirmung darstellt.

Die Seitenwände 37 tragen U-förmige Haltebleche 38, 39 zur Verschraubung des Baugruppenträgers 30 mit den Profilleisten 26 des Schrankrahmens 20.

Die Rückwände der Baugruppenträger 30 sind in ihren Abmessungen gleich, jedoch entsprechend der Verwendung bzw. Aufnahme von Koppelfeldeinrichtungen K1, K2, des Rechners R und der übrigen Anlagenteile in drei unterschiedlichen Ausführungen hergestellt. Dabei ist die Abschirmung durch entsprechende Maßnahmen, wie z. B. zwischengelegte Metallfolien, gewährleistet.

Die Seitenwände 37 sind mit der oberen Wand 31 und der unteren Wand 32 durch Verschränken und Verlappen verbunden. Die U-förmigen Haltebleche 38, 39 sind durch Einpressen (Clinch-Technik) stoffschlüssig mit den Seitenwänden 37 befestigt. Die Luftlöcher 34 in der oberen, unteren und vorderen Wand 31, 32, 33 sind zur Erhaltung der Abschirmung in ihrer Größe so bestimmt, daß eine Störein- und Störabstrahlung bis zu einer Grenzfrequenz verhindert ist. Die Lochgröße ist auf maximal 1/20tel der Wellenlänge der Grenzfrequenz festgelegt. Das heißt für eine Grenzfrequenz von einem Gigahertz beträgt die maximale Lochgröße etwa 15 mm.

Die Baugruppenträger 30 werden linksseitig in die Profilschiene 26 des Schrankrahmens 20 mit dem Halteblech 38 eingehängt. Das rechtsseitige Halteblech 39 wird mit seiner Lochung 391 über die Nase 262 des entsprechenden Befestigungslappens 261 (Fig. 1) gesetzt und mittels Schrauben verbunden. Durch das Einsetzen der Baugruppenträger 30 in den Schrankrahmen 20 entstehen an der rechtsseitigen Profilleiste 26 beim Anschrauben der Haltebleche 39 ein vorderer und ein hinterer Kabelkanal. Da die Verdrahtung über vorgeformte Kabel mit Steckverbindungen vorgenommen wird und für nicht belegte Plätze für Baugruppenträger 30 Kabel vorgeleistet werden, ist ein einfaches Nachrüsten ermöglicht. Dabei ist eine Zuordnung dergestalt gegeben, daß z. B. die Verdrahtung zu externen Anschlüssen im vorderen Kabelkanal, die Internverdrahtung im hinteren Kabelkanal und die Externanschlüsse zu benachbarten Schrankrahmen 20 im Bereich der Kabelverteiler 40 geführt werden.

Auf die Befestigungslappen 261 können zur Unterstützung der Kabelführung Schellen zur Halterung gesteckt werden.

Die Schrankrahmen 20 und die Baugruppenträger 30 sind vorzugsweise aus verzinktem Stahlblech gefertigt.

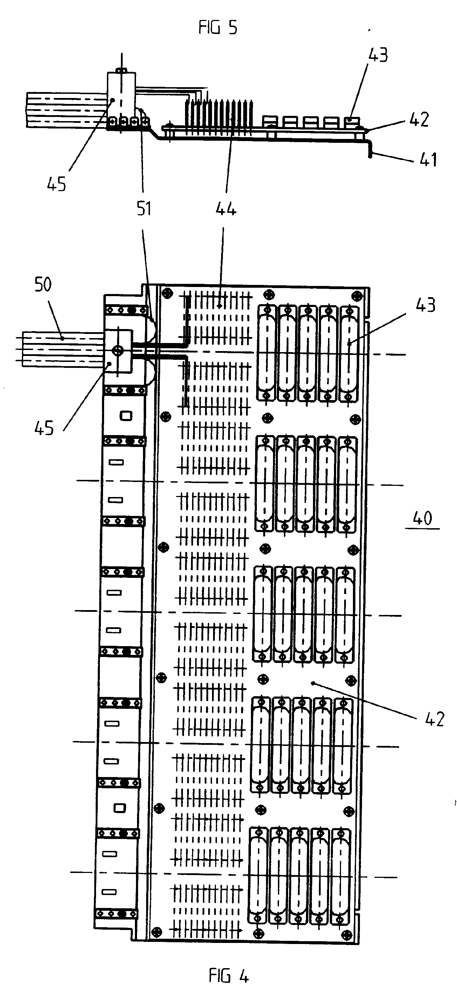

Der Kabelverteiler 40 (Fig. 4, 5) wird in den Schrankrahmen 20 jeweils auf den ersten Baugruppenträgerplatz montiert. Der Kabelverteiler 40 ist aus einem gekröpften Verteilerblech 41 und einer Verteilerbaugruppe 42 zusammengesetzt. Die Verteilerbau-gruppe 42 ist mittels Abstandssäulen auf dem Verteilerblech 41 montiert. Sie besteht aus einer Anreihung von Steckverbindern 43, die der internen Verbindung über Systemkabel der Baugruppenträger 30 untereinander und mit dem benachbarten Schrankrahmen 20 dienen, und einer Wrap-Baugruppen 44 für die Externverdrahtung. Bügelschellen 45 auf dem gekröpften Teil des Verteilerbleches 41 dienen der Halterung der Systemkabel und der Externkabel 50. Die Wrap-Baugruppe 44 und die Steckverbinder 41 stellen praktisch einen Adapter zwischen Extern- und Internverdrahtung dar. Für die durch die Öffnungen der Abdeckung 23 des Schrankrahmens 20 eingeführten Externkabel sind Befestigungen für den Masseanschluß vorgesehen.

Die Zugänglichkeit des Kabelverteilers 40 von nur einer Seite gewährleistet ein Nachrüsten bei einer vorzunehmenden Erweiterung.

## Patentansprüche

1. Aufbausystem für gegen Störein- und Störabstrahlung geschirmte Gehäuse der elektrischen Nachrichtentechnik, bestehend aus auf Sockel (10) gesetzte Stromversorgungseinheiten (11) und darauf befestigte Schrankeinheiten, wobei die Gehäuse reihbar und/oder mit den Rückseiten aneinander stellbar sind, wobei durch Fortlassen von Rückwandteilen und Öffnungen in den Wänden der Schrankeinheiten die interne Verdrahtung geführt wird, wobei jede Schrankeinheit aus einem Schrankrahmen (20), bestehend aus zwei Profilseitenblechen (21, 22), einem Abdeckblech (23) und einem Bodenblech (24) mit Profilleisten (26) an den Innenseiten der Profilseitenbleche (21, 22), sowie an den Profilleisten (26) befestigten Baugruppenträgern (30), die in der Art Faradayscher Käfige gestaltet sind, gebildet ist, wobei durch die Befestigung der Baugruppenträger (30) an den Profilleisten (26) zwei Kabelkanäle gebildet werden und wobei der jeweils obere Platz in den Schrankrahmen (20) durch einen ein gekröpftes Verteilerblech (41) als tragendes Element aufweisenden Kabelverteiler (40) belegt ist.

2. Aufbausystem nach Anspruch 1, dadurch gekennzeichnet, daß das Abdeckblech (23) und das Bodenblech (24) des Schrankrahmens (20) über die gesamte Breite und Tiefe von einer Vielzahl Lochungen zur Wärmeabfuhr durchbrochen sind.

3. Aufbausystem nach Anspruch 1, dadurch gekennzeichnet, daß eine Profilleiste (26) größere Befestigungslappen (261) zur Halterung von Baugruppenträgern (30) und zur Aufnahme von Schellen zur Kabelführung aufweist.

4. Aufbausystem nach Anspruch 2, dadurch gekennzeichnet, daß die Schellen auf die Befestigungslappen (261) gesteckt sind.

5. Aufbausystem nach Anspruch 1, dadurch gekennzeichnet, daß die Profilleisten (26) mit den Seitenwänden (21, 22) durch stoffschlüssiges, punktuelles Einpressen miteinander verbunden sind.

6. Aufbausystem nach Anspruch 1, dadurch gekennzeichnet, daß die Seitenwände (21, 22) kleinere Lochungen zum Einhängen von Verkleidungsteilen aufweisen.

7. Aufbausystem nach Anspruch 1, dadurch gekennzeichnet, daß auf die vorderen Kanten der Seitenwände (21, 22) Leisten (25) zur Halterung von Türen gesetzt sind.

8. Aufbausystem nach Anspruch 1, dadurch gekennzeichnet, daß die obere Wand (31), die untere Wand (32) und die vordere Wand (33) jedes Baugruppenträgers (30) in voller Breite und über die gesamte Tiefe mit Lüftungslöchern (34) versehen sind.

9. Aufbausystem nach Anspruch 8, dadurch gekennzeichnet, daß die Lüftungslöcher (34) der Baugruppenträger (30) kleiner als 1/20tel der Wellenlänge der vorgegebenen maximalen Grenzfrequenz der Störein- und Störabstrahlung sind.

10. Aufbausystem nach Anspruch 1 und 8, dadurch gekennzeichnet, daß die vordere Wand (33) der Baugruppenträger (30) abziehbar und über die obere Wand (31) schiebbar ist.

11. Aufbausystem nach Anspruch 1 und 8, dadurch gekennzeichnet, daß die vordere Wand (33) an ihren Seiten zu Falzen (331) gebogen ist, die eingeschnitten sind.

12. Aufbausystem nach Anspruch 1, dadurch gekennzeichnet, daß die Baugruppenträger (30) Seitenwände (37) mit U-förmigen Halteblechen (38, 39) aufweisen, die durch stoffschlüssiges Einpressen untereinander verbunden sind.

13. Aufbausystem nach Anspruch 1, dadurch gekennzeichnet, daß der Kabelverteiler (40) aus einem Verteilerblech (41) mit einer auf Abstandssäulen gesetzten Verteilerbaugruppe (42) besteht, die aus einer Reihe von Steckverbindern (43) und einer Wrap-Baugruppe (44) zusammengesetzt ist und daß der gekröpfte Teil Bügelschellen (45) als Kabelhalterungen trägt.

## Claims

1. Assembly system for electrical telecommunications engineering housings which are screened against noise immission and noise emission, comprising power supply units (11) placed on bases (10) and cabinet units fixed to them, it being possible for the housings to be placed side by side and/or with their backs together, the internal wiring being fed through omitted rear wall parts and openings in the walls of the cabinet units, each cabinet unit being formed of a cabinet frame (20), comprising two profile side plates (21, 22), a cover plate (23) and a base plate (24) with profile strips (26) on the internal sides of the profile side plates (21, 22), and racks (30), designed in the manner of Faraday cages, fixed to the profile strips (26), two cable ducts being formed through the fixing of the racks (30) to the profile strips (26) and the upper space in each cabinet frame (20) being occupied by a cable distributor (40) having an offset distributor plate (41) as a load-bearing element.

2. Assembly system according to Claim 1,
characterized in that the cover plate (23) and the base plate (24) of the cabinet frame (20) are perforated by a multiplicity of holes for heat dissipation over the entire width and depth.

3. Assembly system according to Claim 1,
characterized in that a profile strip (26) has relatively large fixing lugs (261) for mounting racks (30) and to accommodate clips for cable feed.

4. Assembly system according to Claim 2,
characterized in that the clips are placed on the fixing lugs (261).

5. Assembly system according to Claim 1,
characterized in that the profile strips (26) are connected together with the side walls (21, 22) by constraining spot-wise press-fitting.

6. Assembly system according to Claim 1,
characterized in that the side walls (21, 22) have smaller holes for attaching cladding components.

7. Assembly system according to Claim 1,
characterized in that strips (25) for the mounting of doors are placed on the front edges of the side walls (21, 22).

8. Assembly system according to Claim 1,
characterized in that the upper wall (31), the lower wall (32) and the front wall (33) of each rack (30) are provided with ventilation holes (34) across the full width and over the entire depth.

9. Assembly system according to Claim 8,
characterized in that the ventilation holes (34) of the racks (30) are less than 1/20th of the wavelength of the specified maximum limit frequency of the noise immission and noise emission.

10. Assembly system according to Claim 1 and 8,
characterized in that the front wall (33) of the racks (30) can be removed and pushed over the upper wall (31).

11. Assembly system according to Claim 1 and 8,
characterized in that at its sides the front wall (33) is curved into folds (331) which are slit.

12. Assembly system according to Claim 1,
characterized in that the racks (30) have side walls (37) with U-shaped retaining plates (38, 39) which are connected together by means of constraining press-fitting.

13. Assembly system according to Claim 1,
characterized in that the cable distributor (40) comprises a distributor plate (41) with a distributor module (42) placed on spacer pillars and comprising a series of connectors (43) and a wrap module (44) and that the offset part carries clamp-type clips (45) as cable mountings.

## Revendications

1. Système de construction pour enceintes blindées contre la réception et l'émission d'ondes parasites, utilisée en technique électrique de télécommunications, composé d'unités d'alimentation en courant (11) montées sur des socles (10) et d'unités d'armoires fixées sur ces unités d'alimentation, les enceintes pouvant être juxtaposées en une rangée ou être placées dos contre dos, le câblage interne étant possible par suppression de parties des parois arrières et par des ouvertures dans les parois des unités d'armoires, chaque unité d'armoire étant formée d'un cadre d'armoire (20) comprenant deux tôles latérales (21, 22), une tôle de dessus (23) et une tôle de fond (24), avec des profilés (25) sur les côtés intérieurs des tôles latérales (21, 22), ainsi qu'avec des supports de modules (30) qui sont fixés aux profilés (26) et sont réalisés à la manière de cages de Faraday, deux canaux à câbles étant formés par la fixation des supports de modules (30) aux profilés (26) et l'emplacement supérieur dans chaque cadre d'armoire (20) étant occupé par un distributeur de câbles (40) présentant une tôle de distribution (41) contrecoudée en tant qu'élément porteur.

2. Système de construction suivant revendication 1, caractérisé par le fait que la tôle de dessus (23) et la tôle de fond (24) du cadre d'armoire (20) sont percées d'une multitude de trous d'évacuation de chaleur sur toute la largeur et profondeur.

3. Système de construction suivant revendication 1, caractérisé par le fait qu'un profilé (26) présente des pattes de fixation (261) plus grandes pour le maintien de supports de modules (30) et pour recevoir des colliers pour le maintien des câbles.

4. Système de construction suivant revendication 2, caractérisé par le fait que les colliers sont emboîtés sur les pattes de fixation (261).

5. Système de construction suivant revendication 1, caractérisé par le fait que les profilés (26) sont reliés aux tôles latérales (21, 22) par une liaison par matière obtenue par enfoncement ponctuel.

6. Système de construction suivant revendication 1, caractérisé par le fait que les tôles latérales (21, 22) présentent des plus petits trous pour l'accrochage de parties de revêtement.

7. Système de construction suivant revendication 1, caractérisé par le fait que des profilés (25) sont rapportés sur les arêtes avant des tôles latérales (21, 22) en vue du maintien de portes.

8. Système de construction suivant revendication 1, caractérisé par le fait que la paroi supérieure (31), la paroi inférieure (32) et la paroi avant (33) de chaque support de modules (30) sont munies de trous d'aération (34) sur toute la largeur et sur toute la profondeur.

9. Système de construction suivant revendication 8, caractérisé par le fait que les trous d'aération (34) des supports de modules (30) sont plus petits que 1/20ème de la longueur d'onde de la fréquence limite maximale prédéterminée des ondes parasites reçues ou émises.

10. Système de construction suivant revendication 1 et 8, caractérisé par le fait que la paroi avant (33) des supports de modules (30) peut être retirée et être glissée sur la paroi supérieure (31).

11. Système de construction suivant revendication 1 et 8, caractérisé par le fait que la paroi avant (33) est conformée sur ses côtés sous la forme de plis (331) avec découpes.

12. Système de construction suivant revendication 1, caractérisé par le fait que les supports de modules (30) présentent des parois latérales (37) avec des tôles de maintient (38, 39) en U reliées entre elles par des liaisons par matière obtenues par enfoncement.

13. Système de construction suivant revendication 1, caractérisé par le fait que le distributeur de câble (40) se compose d'une tôle de distribution (41) avec un module de distribution (42) placé sur des colonnes-entretoises et composé d'une rangée de connecteurs à enfichage (43) et d'un module (44) à connexions enroulées et que la partie contrecoudée porte des colliers (45) en forme d'étrier pour le maintien des câbles.
